# EUROPEAN PATENT APPLICATION

(11) **EP 4 224 695 A1**
(43) Date of publication of application: **09.08.2023**
(21) Application number: 21874899.4
(22) Date of filing: 03.08.2021
(51) Int. Cl.: H02M 7/48

(54) **POWER CONVERSION UNIT, POWER CONVERSION DEVICE, AND METHOD FOR INSPECTING POWER CONVERSION UNIT**

(30) Priority: 29.09.2020 JP 2020162933
(71) Applicant: Hitachi, Ltd., Chiyoda-ku Tokyo 100-8280 (JP)
(72) Inventor: MOTEKI, Ryou, Tokyo 100-8280 (JP); MOROOKA, Hisashi, Tokyo 100-8280 (JP); TAKEDA, Shintarou, Tokyo 100-8280 (JP); ABE, Makoto, Tokyo 100-8280 (JP); KAMIZUMA, Hiroshi, Tokyo 100-8280 (JP); NAKATSU, Kinya, Tokyo 100-8280 (JP)
(74) Representative: Mewburn Ellis LLP
(86) International application number: PCT/JP2021/028797
(87) International publication number: WO 2022/070596

(57) **Abstract**

This power conversion unit (U) includes a cooling path (11) positioned between an input-side power converter (14) and an output-side power converter (15) arranged separately on two sides that face each other. The input-side and output-side power converters (14, 15) includes a mold resin (9) filled into a space (p) on the inside of housings (5a, 5b); a switching element (1) covered by the mold resin (9), an upper electrode plate (7) connected to the switching element (1), and a heat dissipation plate (12) having insulating properties connected to the upper electrode plate (7); and a lower electrode (8) provided near the cooling path. The mold resin is an organopolysiloxane having a three-dimensionally crosslinked structure after curing, in which the elastic modulus at room temperature is 0.1 MPa or greater, and the value when the hardness after curing is 10 or greater as measured using a durometer type E.

## Description

### Technical Field

The present invention relates to a power conversion unit, a power conversion device, and a method for inspecting the power conversion unit.

### Background Art

Due to a raise in awareness about global warming problems in recent years and in order to reduce carbon dioxide emissions, hybrid automobiles and electric automobiles using an engine and a motor as power sources have been rapidly spreading as electric vehicles. Power is changed from an engine requiring fossil fuel to a motor due to electrification. Non-use of fossil fuel reduces the carbon dioxide emissions, and thus can contribute to a decrease in global warming.

In a case where a motor is used as a power source, a power conversion device for controlling rotation of the motor is required. The power conversion device is an indispensable device to improve the operation efficiency of the motor in a hybrid vehicle, an electric vehicle, and other products. In accordance with progress in the motorization by motor drive in various fields, the use environment of a power conversion device also changes. For example, an altitude at which the power conversion device is used becomes high, the air pressure drops.

According to Paschen's law, it is known that the insulation performance of a gas deteriorates as the air pressure drops. Due to the deterioration of the insulation performance, partial discharge easily occurs, and the partial discharge causes electrical breakdown. Therefore, in order to enhance the reliability of the power conversion device, measures for preventing partial discharge from occurring even in a low air pressure environment are required. In addition, since electronic components such as a switching element and a power module generate heat during operation of the power conversion device, heat dissipation is also required.

In order to improve heat dissipation of the switching element and the power module, a method for disposing a heat dissipation plate is described in PTL 1 and PTL 2.

### Citation List

### Patent Literature

PTL 1: JP 2015-56925 A (paragraph 0010, FIG. 1(c), etc.)
PTL 2: JP 2005-287267 A (paragraph 0014, FIG. 3, etc.)

### Summary of Invention

### Technical Problem

PTL 1 aims to achieve three of prevention of surge voltage, high heat dissipation of a switching element, and prevention of ringing. In a heat dissipation measure for heat dissipation, the heat dissipation plates (heat dissipation plates 3h and 4h in FIG 1(c) of PTL 1) are connected to the switching element.

In PTL 2, in order to reduce a floating inductance generated between power modules, a heat dissipation plate (cooling substrate 10b in FIG. 2 of PTL 2) of a conductor is disposed on back surfaces of the power modules. Both PTL 1 and PTL 2 describe a heat dissipation method, but do not describe measures against partial discharge in a low air pressure environment. Further, since the present invention and both PTL 1 and PTL 2 are different from each other in a structure of target devices, the problem is not solved even by using the disclosed contents, and thus a new method is required.

The present invention has been made in view of the above circumstances, and an object of the present invention is to provide a power conversion unit, a power conversion device, and a method for inspecting the power conversion unit capable of reducing partial discharge in a low air pressure environment.

### Solution to Problem

In order to solve the above problem, a power conversion unit of the present invention includes a cooling path disposed between an input-side power converter and an output-side power converter, the input-side power converter and the output-side power converter being installed separately on two sides that face each other. The input-side power converter and the output-side power converter each include a mold resin with which a space inside a housing where a wiring board is disposed is filled; a switching element disposed in the space and covered with the mold resin, an upper electrode plate connected to the switching element and covered with the mold resin, a heat dissipation plate having an insulating property connected to the upper electrode plate and covered with the mold resin, and a lower electrode disposed in contact with or in close proximity to the cooling path. The mold resin is organopolysiloxane having a three-dimensional cross-linked structure after being curing, and has an elastic modulus of 0.1 MPa or greater at room temperature and a hardness of 10 or greater after being cured, a value of the hardness being measured with a durometer type E.

### Advantageous Effects of Invention

According to the present invention, a power conversion unit, a power conversion device, and a method for inspecting the power conversion unit capable of reducing partial discharge in a low air pressure environment can be provided.

### Brief Description of Drawings

[FIG. 1A] FIG. 1A is a perspective view of a power conversion unit according to a first embodiment of the present invention.
[FIG. 1B] FIG. 1B is a cross-sectional view taken along line I-I of FIG. 1A illustrating the power conversion unit according to the first embodiment of the present invention.
[FIG. 2] FIG. 2 is a view of a state in which a switching element, an upper electrode plate, and a heat dissipation plate are mounted as viewed from arrow II in FIG. 1B.
[FIG. 3] FIG. 3 is a cross-sectional view taken along line I-I of FIG. 1A illustrating the power conversion unit according to the first embodiment of the present invention.
[FIG. 4] FIG. 4 is a diagram in which the power conversion unit of the first embodiment is divided into an input-side unit and an output-side unit.
[FIG. 5] FIG. 5 is an equivalent cross-sectional view taken along line I-I of FIG. 1A illustrating a power conversion unit of a second embodiment.
[FIG. 6] FIG. 6 is an equivalent cross-sectional view taken along line I-I of FIG. 1A illustrating a power conversion unit of a third embodiment.
[FIG. 7] FIG. 7 is an equivalent cross-sectional view taken along line I-I of FIG. 1A illustrating a power conversion device of a fourth embodiment.
[FIG. 8] FIG. 8 is a diagram illustrating an example of a circuit of a fifth embodiment applied to the power conversion units of the first to fourth embodiments.
[FIG. 9] FIG. 9 is a diagram illustrating a flow of a screening method for a power conversion unit of a sixth embodiment.

### Description of Embodiments

Hereinafter, preferred embodiments for carrying out the present invention will be described with reference to the drawings. Note that the following is merely an example of implementation, and the contents of the invention are not limited to the following specific embodiments. The present invention can be naturally modified into various modes including the following modes.

### <<First embodiment>>

In the first embodiment, a power conversion unit in which an insulating heat dissipation plate is connected to an upper electrode plate will be described.

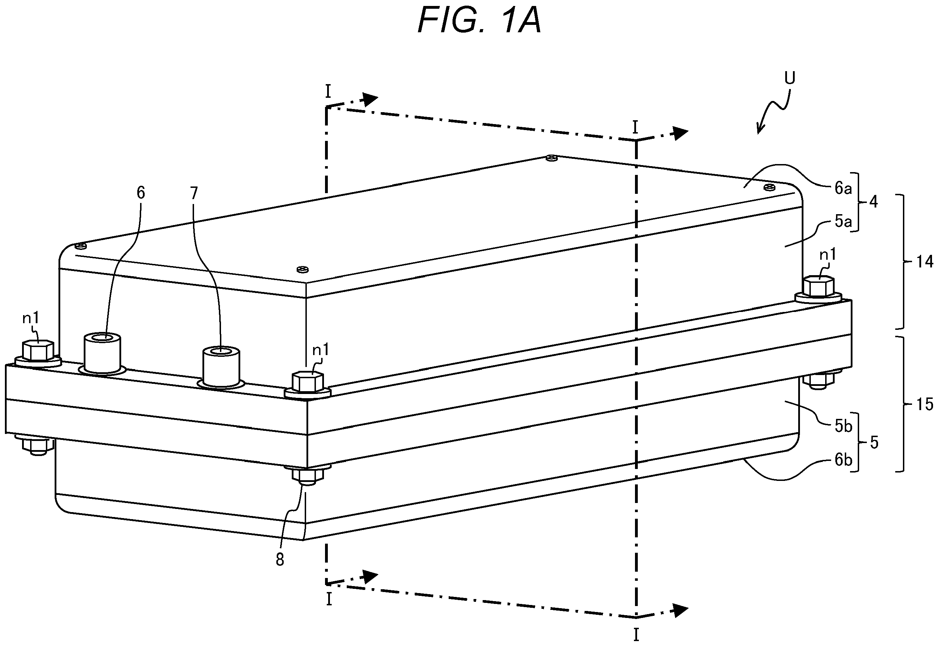

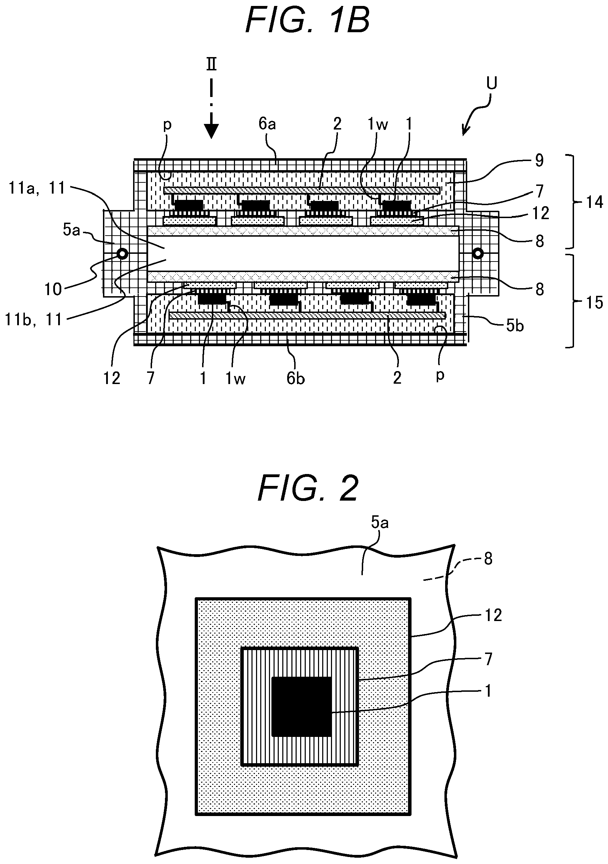

FIG. 1A is a perspective view of a power conversion unit U according to the first embodiment of the present invention. FIG. 1B is a cross-sectional view taken along line I-I of FIG. 1A illustrating the power conversion unit U according to the first embodiment of the present invention.

The power conversion unit U of the first embodiment includes an input-side unit (input-side power converter) 14 on an input side and an output-side unit (output-side power converter) 15 on an output side.

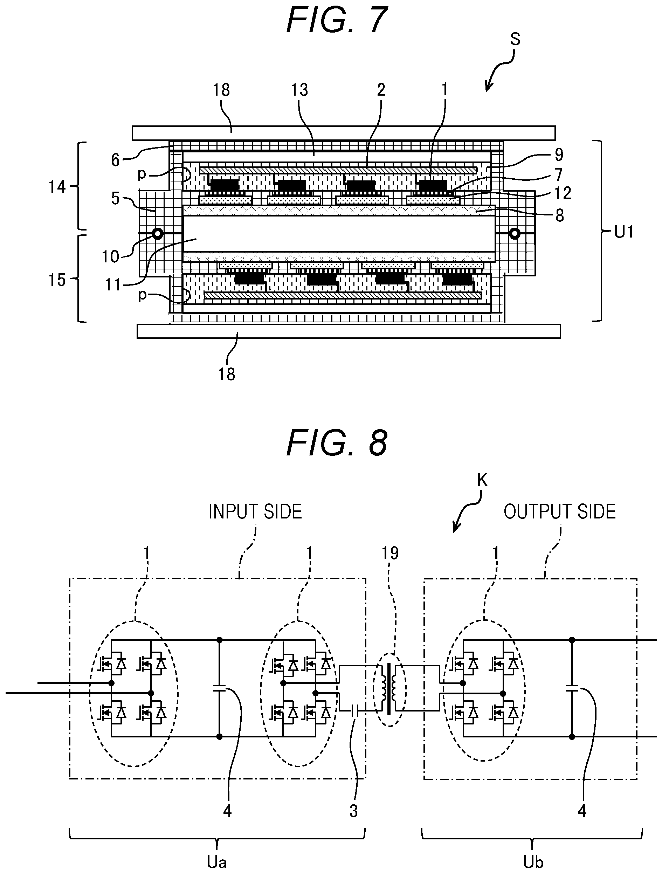

The power conversion unit U includes switching elements 1 (see FIG. 1B), a wiring board 2, a resonant capacitor 3 (see FIG. 8), a smoothing capacitor 4 (see FIG. 8), housings 5a and 5b, housing lids 6a and 6b, and components pursuant thereto. In the power conversion unit U, an outer shell is formed by the housing 5a and the housing lid 6a on the input side, and the housing 5b and the housing lid 6b on the output side.

Since the input-side unit 14 and the output-side unit 15 have similar configurations, the components of the output-side unit 15 on the output side are denoted by the same reference numerals as the reference numerals of the input-side unit 14, and detailed description about them is omitted.

In the power conversion unit U illustrated in FIG. 1B, the wiring board 2 is provided inside the housing 5a and the housing lid 6a on the input side, and the housing 5b and the housing lid 6b on the output side. The switching elements 1, the resonant capacitor 3 (see FIG. 8), the smoothing capacitor 4 (see FIG. 8), and the like are mounted on the wiring board 2.

As illustrated in FIG. 1B, all the switching elements 1 are connected to an upper electrode plate 7.

A heat dissipation plate 12 having insulating property is connected to the upper electrode plate 7. The heat dissipation plate 12 has insulating property and good thermal conductivity. The heat dissipation plate 12 is wider (has a larger area) than the upper electrode plate 7. As a result, the heat transferred from the upper electrode plate 7 to the heat dissipation plate 12 spreads to the wide heat dissipation plate 12 and is dissipated, thereby improving heat extraction and heat dissipation of the switching elements 1 (details will be described later).

In the power conversion unit U, the power converter having a power conversion function is divided into an input-side unit 14 on one side and an output-side unit 15 on the other side, and these units are disposed to face each other. A cooling path 11 formed by both the units (14 and 15) is disposed between the input-side unit 14 and the output-side unit 15 facing each other. The cooling path 11 is formed by an input-side cooling path 11a and an output-side cooling path 11b.

A cooling medium for cooling both the units (14 and 15) flows through the cooling path 11.

In order to prevent leakage of the cooling medium flowing through the cooling path 11 from between the input-side unit 14 and the output-side unit 15, O-rings 10 (second sealing materials) are disposed between the input-side unit 14 and the output-side unit 15. Interposing the O-rings 10 can reduce the leakage of the cooling medium from between the input and output-side units 14 and 15.

A lower electrode plate 8 is disposed respectively on surfaces in contact with the cooling path 11 on both the input side (upper side in FIG. 1B) and the output side (lower side in FIG. 1B). Note that the lower electrode plate 8 may be disposed near the cooling path 11. The lower electrode 8 has a ground potential.

The heat dissipation plate 12 is disposed adjacent to the lower electrode 8.

The upper electrode plate 7 is disposed adjacent to the heat dissipation plate 12. The switching elements 1 are disposed to be electrically and thermally connected to the upper electrode plate 7. Terminals of the switching elements 1 are connected to the upper electrode plate 7. The switching elements 1 are heat generating components, and are in contact with the upper electrode plate 7 to be thermally conducted. The heat of the switching elements 1 is conducted to the heat dissipation plate 12 having insulating property through the upper electrode plate 7, and is exchanged with the cooling medium to be extracted.

FIG. 2 is a view of a state in which the switching element 1, the upper electrode plate 7, and the heat dissipation plate 12 are mounted as viewed from arrow II in FIG. 1B.

The upper electrode plate 7 is wider than the switching element 1, and the switching element 1 is disposed at a center of the upper electrode plate 7. Similarly, the heat dissipation plate 12 is wider (has a larger area) than the upper electrode plate 7, and the upper electrode plate 7 is disposed at a position away from a side edge and close to the center of the heat dissipation plate 12. This increases a creepage distance between the upper electrode plate 7 and the lower electrode plate 8 (see FIG. 1B), thereby improving the insulating property between the upper electrode plate 7 and the lower electrode plate 8.

As a result, the insulation between the input side (the upper side in FIG. 1B) and the output side (the lower side in FIG. 1B) of the power converter is secured, and the heat of the switching element 1 is easily dissipated to the cooling path 11.

Although alumina is used as the heat dissipation plate 12 in the first embodiment, the heat dissipation plate is not particularly limited as long as the plate is made of a material having insulating property and a high heat dissipation property. Examples of the material of the heat dissipation plate 12 other than alumina include aluminum nitride and silicon nitride as inorganic substances, and epoxy resins containing alumina and aluminum nitride as organic substances.

In order to perform power conversion, electronic components such as the resonant capacitor 3 and the smoothing capacitor 4 illustrated in FIG. 8 to be described later are mounted on the wiring board 2 in addition to the switching elements 1.

A space p in each of the input-side and output-side units 14 and 15 where the switching elements 1, the wiring board 2, the resonant capacitor 3, the smoothing capacitor 4, the upper electrode plate 7, and the like on each of the input side (the upper side in FIG. 1B) and the output side (the lower side in FIG. 1B) illustrated in FIG. 1B are disposed is filled with a mold resin 9 to be solid-insulated. The mold resin 9 is a silicone coating material that has fluidity in an uncured state and does not have fluidity after curing.

The silicone coating material is a material harder than silicone gel. In the present specification, the silicone coating material is an organopolysiloxane having a three-dimensional cross-linked structure after curing, and has an elastic modulus at room temperature of 0.1 MPa or greater and a hardness after curing of 10 or greater as measured by a durometer type E described in Japanese Industrial Standard (JIS) K6253-3.

In a case where the hardness of the silicone coating material is high and cannot be measured by the durometer type E, the measured values obtained by the durometers type A and type D are the hardness. Note that since the silicone gel is soft, the hardness cannot be measured by a durometer, and the hardness is measured by a penetration test shown in JIS K6249.

In general, a silicone gel is used for a silicone-based mold resin. As compared to the silicone gel, defects that become electrical weaknesses, such as bubbles and separation, are less likely to be caused on the silicone coating material in a low air pressure environment. This is because the silicone coating material has self-adhesiveness and is excellent in adhesiveness. On the other hand, non-adhesiveness of the silicone gel easily causes separation, and bubbles are likely to be caused due to the separation.

Furthermore, since the hardness of the silicone coating material is higher than that of the silicone gel, the silicone coating material is hardly deformed. For this reason, the silicone coating material has a property of being hardly deformed, and thus can reduce bubbles caused by separation under a low air pressure environment.

The silicone coating material has fluidity in an uncured state, and the viscosity in the uncured state is preferably 20 Pa-s or smaller at room temperature from the viewpoint of a casting property during die molding and a degassing property to reduce bubble generation during die molding. When the mold resin 9 has a high viscosity, it is difficult to cast the mold resin 9 and degas air remaining in the mold resin 9 during die molding. Therefore, bubbles remain in a cured product, and the remaining bubbles deteriorate the electrical insulating property, resulting in an electrical weakness.

Two types of silicone coating materials including an addition reaction type material and a condensation reaction type material are present, and the addition reaction type material is preferable. With the condensation reaction type material, a compound having a low molecular weight is generated during a curing reaction, and this might cause generation of bubbles. For the similar reason, the silicone coating material preferably contains a less amount of a siloxane compound having a low molecular weight.

Semiconductor elements of the switching elements 1 used in the power conversion unit U and a bonding wire for electrically connecting the semiconductor elements to the wiring board 2 are sealed with an epoxy resin or the like. In the power conversion unit U, a lead 1w (see FIG. 1B) of a conducting portion is exposed to the outside. Therefore, in the switching element 1, breakage of the bonding wire does not have to be considered, and thus the silicone coating material can be used. In the switching element 1 having the structure in which the bonding wire is exposed, a silicone gel that is softer and is less elastic than the silicone coating material is used in order to prevent the breakage of the bonding wire. By using the silicone gel for the mold resin 9, a force applied to the bonding wire and bonding portions between the bonding wire and the switching element 1 and between the bonding wire and the wiring board 2 is weakened.

As the silicone coating material, specifically, products of Dow Toray Co., Ltd. including 184, SH850, SE1816CV, and SE1817CVM (trade names) can be used. In particular, SE1816CV and SE1817CVM are preferably used. As for the products of Shin-Etsu Chemical Co., Ltd., KE-1204, KE-1282, KE-109 E, KE-1846, and KE-1886 (trade names) can be used.

The heat dissipation plate 12 having insulating property is molded integrally with the housings 5a and 5b. The integral molding facilitates the manufacturing, and thus can shorten a process for manufacturing the power conversion unit U. Glass fiber-reinforced polyphenylene sulfide (PPS) is used for the housings 5a and 5b on the input and output sides and the housing lids 6a and 6b on the input and output sides, but their material is not particularly limited. Examples of other materials forming the housings 5a and 5b and the housing lids 6a and 6b include acrylnitrile-butadiene-styrene copolymer (ABS) resin, polyamide, epoxy resin, and unsaturated polyester resin. A linear expansion coefficient of the housing material is preferably made to be close to coefficients of the upper electrode plate 7, the lower electrode plate 8, and the heat dissipation plate 12 in order to prevent separation from adjacent components and cracking.

By filling the space p in the housings 5a and 5b where the wiring board 2 is disposed with the mold resin 9 and performing solid insulation, the insulating property of the space p inside the input and output-side units 14 and 15 can be maintained even if the air pressure drops. Therefore, occurrence of partial discharge of electronic components such as the switching element 1 mounted on wiring board 2 can be reduced.

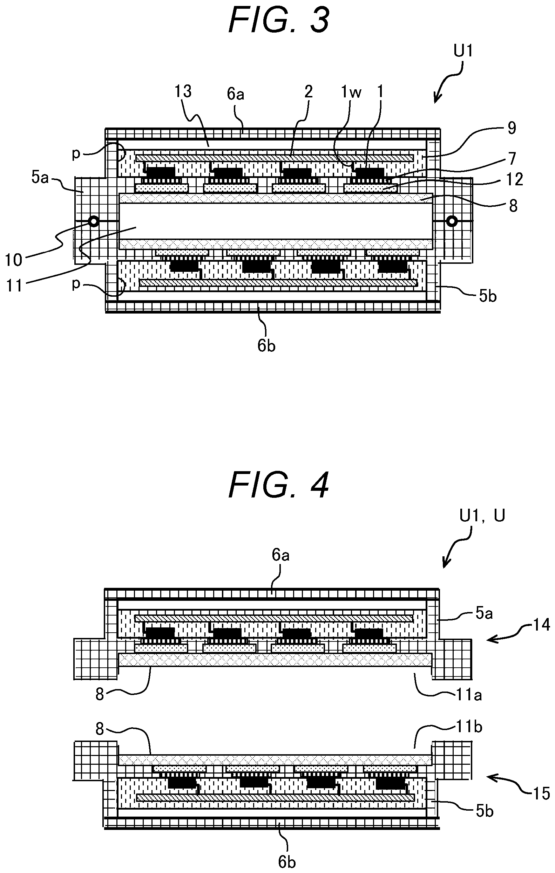

FIG. 3 is a cross-sectional view taken along line I-I of FIG. 1A illustrating the power conversion unit U1 of another example according to the first embodiment of the present invention.

In the power conversion unit U1 of another example, an unfilled portion 13 that is not filled with the mold resin 9 is formed in the space p where the wiring board 2 is disposed. Other parts of the configuration are similar to those of the power conversion unit U illustrated in FIGS. 1A and 1B, and are thus denoted by the same reference numerals.

In the power conversion unit U1, the uncured mold resin 9 is inserted from the portions where the wiring board 2 is present on both the input side and the output side, is made to react, and is solidified. At this time, the unfilled portion 13 may be formed by reducing the amount of the mold resin 9.

As a result, even if the mold resin 9 expands due to heat generated in the switching element 1, the unfilled portion 13 can receive (allow) the expansion of the mold resin 9.

FIG. 4 is a view in which the power conversion unit U1 of the first embodiment is divided.

The power conversion units U1 and U can be divided into the input-side unit 14 and the output-side unit 15. The input-side unit 14 and the output-side unit 15 are fixed with bolts n1 (see FIG. 1A) via the O-rings 10 (see FIG. 3).

As a result, the input-side unit 14 and the output-side unit 15 can individually undergo insulation testing. Therefore, discarding only defective products at the time of insulation failure or maintenance leads to a reduction of waste.

### <<Second embodiments

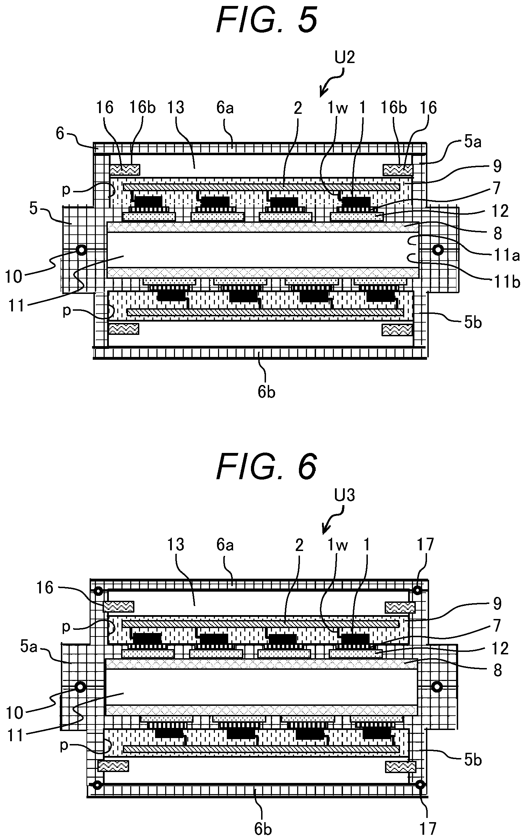

FIG. 5 is an equivalent cross-sectional view taken along line I-I of FIG. 1A illustrating a power conversion unit U2 of a second embodiment.

The power conversion unit U2 of the second embodiment has a configuration where a moisture absorbent 16 such as silica gel is disposed in the unfilled portion 13. Other parts of the configuration are similar to those of the power conversion unit U1 of the another example in FIG. 3, are denoted by the same reference numerals, and detailed description thereof is omitted.

The power conversion unit U2 has a place 16b where the moisture absorbent 16 such as silica gel is put in the same space as the space p filled with the mold resin 9. Specifically, the place 16b where the moisture absorbent 16 is put is disposed in the unfilled portion 13.

Moisture absorption by the mold resin 9 can be reduced by the moisture absorbent 16 absorbing moisture in the space p. For this reason, the insulating property of the mold resin 9 can be maintained.

Therefore, the insulating property of the mold resin 9 is maintained, and the effect of reducing partial discharge is maintained.

### <<Third embodiments

FIG. 6 is an equivalent cross-sectional view taken along line I-I of FIG. 1A illustrating a power conversion unit U3 of a third embodiment.

The power conversion unit U3 of the third embodiment has a configuration where airtightness of the space p where the wiring board 2 is disposed is maintained. Other parts of the configuration are similar to those of the power conversion unit U1 of the another example in FIG. 3, are denoted by the same reference numerals, and detailed description thereof is omitted.

In the power conversion unit U3, a housing lid O-ring 17 (first sealing material) is disposed at a portion where the housing 5a and the housing lid 6a on the input side are fitted, and similarly, a housing lid O-ring 17 is disposed at a portion where the housing 5b and the housing lid 6b on the output side are fitted.

The housing lid O-ring 17 id disposed between the housing lid 6a and the housing 5a and between the housing lid 6b and the housing 5b, thereby improving the airtightness of the internal space p between the housing 5a and the housing lid 6a on the input side and between the housing 5b and the housing lid 6b on output side.

Therefore, the inflow of moisture into the power conversion unit U3 can be reduced. Thus, the moisture absorbent 16 such as silica gel and the moisture absorption of the mold resin 9 can also be reduced.

As a result, the insulating property of the mold resin 9 is maintained, and the effect of reducing partial discharge is maintained.

### <<Fourth embodiment>>

FIG. 7 is an equivalent cross-sectional view taken along line I-I of FIG. 1A illustrating a power conversion device S of a fourth embodiment.

The fourth embodiment describes a configuration of the power conversion device S to which the power conversion unit U1 is applied.

In the power conversion device S of the fourth embodiment, an intra-panel frame 18 (frame) is disposed in the power conversion unit U1 (FIG. 2).

The power conversion device S includes the grounded intra-panel frame 18 outside the input-side unit 14 and the output-side unit 15. Grounding of the intra-panel frame 18 can prevent electric shock at the time of touching the power conversion device S.

In addition, the power conversion unit U1 can be used not only alone but also by connecting a plurality of power conversion units and installing them on the intra-panel frame 18. This can prevent an electric shock at the time of connecting the plurality of the power conversion units U1 and touching the high-voltage power conversion device S installed on the intra-panel frame 18.

Note that the power conversion units U, U2, and U3 described above can be naturally applied to the power conversion device S.

### <<Fifth embodiment>>

FIG. 8 illustrates an example of a circuit K of a fifth embodiment.

In the fifth embodiment, the circuit K used in the power conversion units U to U3 of the first to third embodiments will be described.

The switching elements 1 and the smoothing capacitor 4 are disposed in the input-side unit 14 on the input side and the output-side unit 15 on the output side illustrated in FIG. 1B. For example, an insulated gate bipolar transistor (IGBT), a metal-oxide-semiconductor field-effect transistor (MOSFET), gallium nitride (GaN), silicon (Si), silicon carbide (SiC), or the like is applied to the switching elements 1.

The resonant capacitor 3 is disposed in the input-side unit 14, and the input side and the output side are connected via a radio frequency transformer 19.

According to the above configuration, in the power conversion units U to U3, partial discharge can be prevented by filling the space p where the wiring board 2 is disposed with the mold resin 9.

In addition, by connecting the heat dissipation plate 12 having insulating property wider than the upper electrode plate 7 to upper electrode plate 7, both insulation between upper electrode plate 7 and the lower electrode plate 8 and heat dissipation can be achieved.

Further, since the cooling path 11 is disposed between the input-side unit 14 and the output-side unit 15 of the power converter, the electronic components such as the switching elements 1 of the input-side unit 14 and the output-side unit 15 can be cooled by one cooling path 11. That is, in the power conversion units U to U3, it is possible to achieve both an insulating structure where partial discharge does not occur even in a high-altitude and low-air pressure environment and a heat dissipation structure for heat generated from the switching elements 1.

### <<Sixth embodiment>>

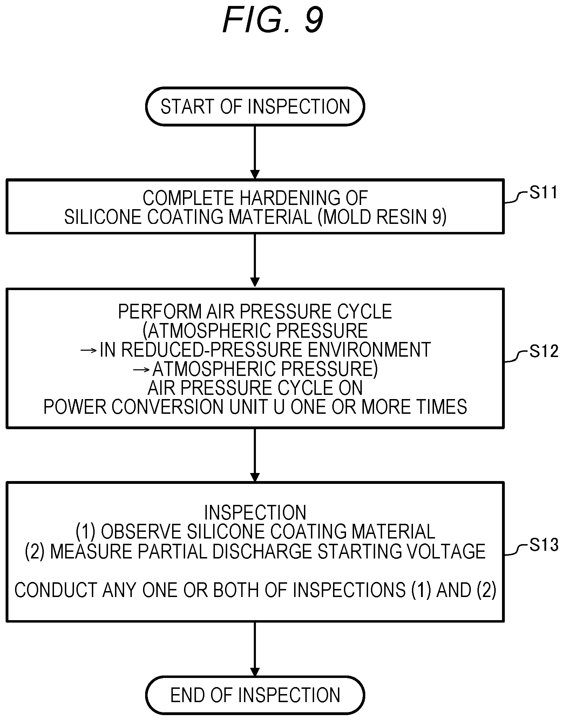

FIG. 9 illustrates a screening method for the power conversion unit U of a sixth embodiment.

The sixth embodiment describes the screening method for the power conversion unit U (U1, U2, and U3).

### <Screening Method>

The screening method for the power conversion unit U is performed as follows.

After the silicone coating material molded as the power conversion unit U is cured (step S11 in FIG. 9), an air pressure cycle is performed on the power conversion unit U one or more times (step S12 in FIG. 9). In the air pressure cycle, the power conversion unit U under the atmospheric pressure is placed in an environment where an air pressure is lower than the atmospheric pressure, and the power conversion unit U is returned to the atmospheric pressure. This process is defined as one cycle.

Here, the air pressure and the retention time under the low air pressure environment are not particularly limited, and can be changed in accordance with individual purposes. However, the air pressure cycle needs to be performed one or more times. This is because the silicone coating material is likely to be separated and bubbles are likely to be caused by applying the stress of an air pressure change to the power conversion unit U. Therefore, a bubble-generated article can be found by performing one or more air pressure cycles. The number of the air pressure cycles is preferably 3 or more cycles.

After the air pressure cycle of the power conversion unit U, as illustrated in step S13 of FIG. 9, a change of the silicone coating material is visually observed or observed with a camera, and the presence or absence of bubbles is checked. Alternatively, a partial discharge starting voltage is measured as an electrical test. This is because the presence or absence of bubbles can be determined by the level of the partial discharge starting voltage. For example, when the partial discharge starting voltage is high, the insulating property tends to be high and the amount of bubbles tends to be small. When the partial discharge starting voltage is low, the insulating property tends to be low and the amount of bubbles tends to be large.

That is, in a case where bubbles or separation is caused in the power conversion unit U by performing the air pressure cycle, the partial discharge starting voltage drops, and thus a failure can be checked.

The visual observation of the silicone coating material forming the power conversion unit U after the air pressure cycle or the electrical test on the power conversion unit U can be freely combined. For example, only the observation of the silicone coating material of the power conversion unit U may be performed, only the measurement of the partial discharge starting voltage of the power conversion unit U may be performed, or both of them may be performed. Since the partial discharge starting voltage varies, the measurement is preferably performed three or more times.

### <First Example of Screening>

The air pressure of the power conversion unit U in the low air pressure environment was kept at 194 hPa for 10 minutes, and the air pressure cycle for the power conversion unit U was performed 5 times. Thereafter, the surface of the silicone coating material (the mold resin 9) forming the power conversion unit U was visually observed, the partial discharge starting voltage was measured three times under atmospheric pressure, and the partial discharge starting voltage was an average value of three times of measurement.

### <Second Example of Screening>

The air pressure of the power conversion unit U in the low air pressure environment was kept at 194 hPa for 10 minutes, and the air pressure cycle for the power conversion unit U was performed 5 times. Thereafter, the surface of the silicone coating material (the mold resin 9) was visually observed, the partial discharge starting voltage was measured 3 times at 194 hPa which is identical to that in the low air pressure environment during the air pressure cycle, and the partial discharge starting voltage was an average value of three times of measurement.

### <<Other embodiments>>

1. The power conversion units U to U3 described in the above embodiments are used as converters.
2. In the above embodiments and the like, various configurations have been described, but these configurations may be appropriately combined.
3. The configurations described in the above embodiments and the like are examples, and various forms and modifications are possible within the scope of claims. Reference Signs List

- 1: switching element
- 2: wiring board
- 3: resonant capacitor
- 4: smoothing capacitor
- 5a, 5b: housing
- 6a, 6b: housing lid
- 7: upper electrode plate
- 8: lower electrode plate (lower electrode)
- 9: mold resin
- 10: O-ring (second sealing material)
- 11: cooling path
- 12: heat dissipation plate
- 13: unfilled portion (unfilled space)
- 14: input-side unit (input-side power converter)
- 15: output-side unit (output-side power converter)
- 16: moisture absorbent
- 17: housing lid O-ring (first sealing material)
- 18: intra-panel frame (frame)
- 19: radio frequency transformer
- p: space
- U, U1, U2, U3, U4: power conversion unit
- S: power conversion device

## Claims

1. A power conversion unit comprising:
a cooling path disposed between an input-side power converter and an output-side power converter, the input-side power converter and the output-side power converter being installed separately on two sides that face each other,
wherein the input-side power converter and the output-side power converter each include
a mold resin with which a space inside a housing where a wiring board is disposed is filled,
a switching element disposed in the space and covered with the mold resin,
an upper electrode plate connected to the switching element and covered with the mold resin,
a heat dissipation plate having an insulating property connected to the upper electrode plate and covered with the mold resin, and
a lower electrode disposed in contact with or in proximity to the cooling path, and
wherein the mold resin is organopolysiloxane having a three-dimensional cross-linked structure after being cured, and has an elastic modulus of 0.1 MPa or greater at room temperature and a hardness of 10 or greater after being cured, a value of the hardness being measured with a durometer type E.

2. The power conversion unit according to claim 1, wherein
the mold resin has a viscosity of 20 Pa·s or smaller at room temperature in an uncured state.

3. The power conversion unit according to claim 1, wherein
the mold resin is an addition reaction resin.

4. The power conversion unit according to claim 1, wherein
the heat dissipation plate is wider than the upper electrode plate, and
the upper electrode plate is disposed away from a side edge of the heat dissipation plate and closer to a center of the heat dissipation plate.

5. The power conversion unit according to claim 1, wherein
the input-side power converter and the output-side power converter are separated from each other.

6. The power conversion unit according to claim 1, wherein
the lower electrode has a ground potential.

7. The power conversion unit according to claim 1, wherein
as the switching element, an insulated gate bipolar transistor (IGBT), a metal-oxide-semiconductor field-effect transistor (MOSFTET), gallium nitride (GaN), silicon (Si), or silicon carbide (SiC) is used.

8. The power conversion unit according to claim 1, wherein
the space contains an unfilled space that is not filled with the mold resin.

9. The power conversion unit according to claim 8, wherein the unfilled space includes a moisture absorbent.

10. The power conversion unit according to claim 1, wherein
the heat dissipation plate and the housing are integrally molded.

11. The power conversion unit according to claim 1, wherein
a first sealing material is disposed between the housing and a housing lid fixed to the housing.

12. The power conversion unit according to claim 5, wherein
a second sealing material is disposed between the input-side power converter and the output-side power converter.

13. The power conversion unit according to claim 1, wherein
the power conversion unit
undergoes an air pressure cycle of being placed in an environment where an air pressure is lower than an atmospheric pressure and being again placed in an atmospheric pressure environment, and undergoes a partial discharge test.

14. A power conversion device, comprising:
the power conversion unit according to any one of claims 1 to 13; and
a frame connected to housing lids fixed to a housing of the input-side power converter and a housing of the output-side power converter, the frame being grounded.

15. A method for inspecting the power conversion unit according to any one of claims 1 to 13, the method comprising:
performing an air pressure cycle in which the power conversion unit is placed in an environment where an air pressure is lower than an atmospheric pressure after curing the mold resin, and is again placed in an atmospheric pressure environment; and
observing a state of the mold resin after performing the air pressure cycle.

16. The method according to claim 15 further comprising conducting a partial discharge test on the power conversion unit after curing the mold resin.

17. A method for inspecting the power conversion unit according to any one of claims 1 to 13, the method comprising:
performing an air pressure cycle in which the power conversion unit is placed in an environment where an air pressure is lower than an atmospheric pressure after curing the mold resin and again placed in an atmospheric pressure environment; and
conducting a partial discharge test on the power conversion unit after curing the mold resin.

18. The method for inspecting the power conversion unit according to claim 15, wherein
the air pressure cycle is performed one or more times.

19. The method for inspecting the power conversion unit according to claim 17, wherein
the air pressure cycle is performed one or more times.
